Europäisches Patentamt

European Patent Office

Office européen des brevets

(19)

(11) Veröffentlichungsnummer: **0 134 541**
A1

# (12) EUROPÄISCHE PATENTANMELDUNG

(21) Anmeldenummer: **84109252.1**

(22) Anmeldetag: **03.08.84**

(51) Int. Cl.⁴: **H 01 B 17/00**
**G 01 B 15/06, H 01 B 17/14**

(30) Priorität: **17.08.83 DE 3329748**

(43) Veröffentlichungstag der Anmeldung:
**20.03.85 Patentblatt 85/12**

(84) Benannte Vertragsstaaten:
**AT BE CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Herold, Georg, Dr.**
**Weingarten**
**D-8620 Lichtenfels(DE)**

(72) Erfinder: **Plack, Bodo**
**Unterlangenstadter Strasse 48**
**D-8627 Redwitz(DE)**

(72) Erfinder: **Buchenau, Reinhard**
**Frankenring 82a**
**D-8555 Adelsdorf(DE)**

(72) Erfinder: **Hartmann, Erwin**
**Friedrich-Bauer-Strasse 34**
**D-8520 Erlangen(DE)**

(54) Stützisolator für Hochspannung.

(57) Ein Stützisolator für Hochspannung, insbesondere aus Kunststoff mit erd- und spannungsseitig eingebauten metallischen Befestigungselementen wie Buchsen (2, 8) oder Metallplatten (5) enthält eine Teilerkapazität, gebildet aus einem, zylindrischen Metallgitter (1) und einem in dieses hineinragenden Metallteil (6) oder dieses konzentrisch umgebenden Metallgitters (4) die jeweils an den metallischen Befestigungselementen angeordnet sind. Einem solchen Teilerstützer kann eine Schaltung angeschlossen sein zur Feststellung oder Anzeige der Hochspannung oder Freigabe oder Sperrung der Betätigung eines Hochspannungsschalters eingesetzt werden.

FIG 1

EP 0 134 541 A1

SIEMENS AKTIENGESELLSCHAFT     Unser Zeichen
Berlin und München             VPA **83 P 3 2 6 4 E**

Stützisolator für Hochspannung

Die Erfindung betrifft einen Stützisolator für Hochspannung nach dem Oberbegriff des Anspruches 1.

Arbeiten in Starkstromanlagen dürfen nur in spannungsfreiem Zustand ausgeführt werden. Zur Zeit wird der Spannungszustand von Anlagenteilen meist mit beweglichen Spannungsprüfern festgestellt. Diese Geräte haben heute einen hohen Sicherheitsstandard erreicht, aber ihre Anwendung ist trotzdem nicht immer gefahrlos, vor allem dann, wenn zum Prüfen Türen geöffnet werden müssen vor Anlagenteilen, die möglicherweise noch unter Spannung stehen. Das Sicherheitsbedürfnis der Anwender und Gesetzgeber führt dazu, daß diese Spannungsprüfer nicht bzw. nur noch bedingt in Schaltanlagen eingesetzt werden und fest in eine Schaltanlage eingebaute Bauteile zur Anzeige des Spannungszustandes herangezogen werden. Solche Einrichtungen bestehen beispielsweise aus einem kapazitiven Spannungsteiler und der davon gespeisten eigentlichen Anzeige, die mit ständig leuchtenden oder blinkenden Glimmlampen arbeitet.

Die dafür erforderliche Teilerkapazität kann in solchen Anordnungen untergebracht sein, die ohnehin feldsteuernde Beläge aufweisen, z.B. in Stromwandlern. Diese sind jedoch nicht in allen Schaltanlagen vorhanden oder nicht an der gewünschten Stelle. In solchen Fällen werden Einrichtungen mit einer definierten Kapazität als Spannungsteiler, z.B. in einem üblichen Stützisolator gebraucht.

Td 2 Gr /08.08.1983

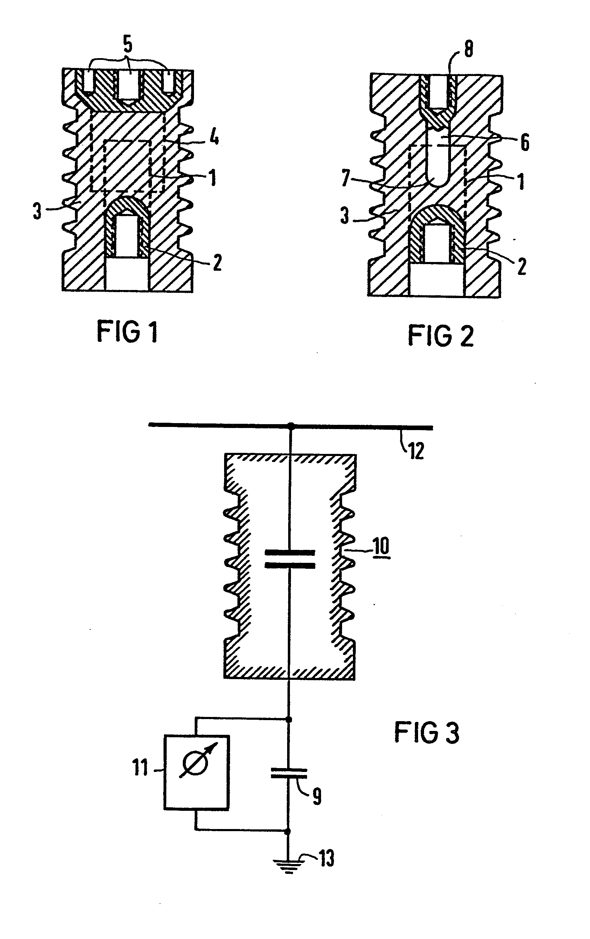

Bei einem Stützisolator gemäß der DE-OS 31 21 795 ist im Innern des Isolators ein kapazitiverSpannungsteiler angeordnet und an seinen hochspannungsfreien Teilen eine elektronische Schaltung angeschlossen. Eine solche Ausführung, bei der gemäß FIG 1 und der bevorzugten Ausführungsform der kapaztive Spannungsteiler aus zwei im Abstand voneinander in den Isolator eingegossenen Elektroden gebildet ist, vorzugsweise Halbkugeln, die einander gegenüberliegen, ist bei dem von der Größe des Normstützers gegebenen maximalen Durchmesser der Halbkugeln und dem von der Durchschlagfestigkeit des Isolierstoffes bestimmten minimalen Abstand der Halbkugeln die erreichbare Kapazität zu gering, um genügend Energie für eine direkte Anzeige aus dem Hochspannungsnetz auszukoppeln. Deshalb ist jedem solchen Stützer eine elektronische Schaltung zur Verstärkung des Signals eingebaut, die im Betrieb nicht zugänglich ist  und daher nicht den Anforderungen hinsichtlich Zuverlässigkeit genügt. Außerdem ist die Anzeige von einer Hilfsspannung abhängig.

Aufgabe der Erfindung ist es, das Sicherheitsproblem zu lösen und Stützisolatoren zu entwickeln mit einer Kapazität, die Spannungsteiler für Hochspannung vornehmlich Betriebsspannungen von $U_m$=12 kV/24 kV/36 kV ermöglicht. Ein solcher Stützer wird weiterhin Teilerstützer genannt. Dabei muß die Kapazität groß genug sein um eine optische Anzeige, z.B. mit einer Glimmlampe oder (LED) direkt speisen zu können, d.h. deutlich größer als mit 2 Halbkugeln erreichbar. Diese Teilerstützer müssen in ihren Anschluß- und Befestigungsmaßen und ihren funktionellen Werten wie Isoliervermögen, Teperaturverhalten, mechanischer Festigkeit und Alterung den üblichen Stützisolatoren entsprechen. Sie sollen den Stützisolator in Lasttrennschaltern, Trennschaltern, Erdungsschaltern, Erdungsdraufschaltern und anderen Schaltanlagen wie Sammelschienenstützern nicht ersetzen, sondern sinnvoll ergänzen.

Diese Aufgabe wird gemäß der Erfindung durch eine Ausführung gemäß den kennzeichnenden Merkmalen des Anspruches 1 gelöst. Das in das zylindrische Metallgitter konzentrisch hineinragende Metallteil kann ein Bolzen sein.
Zwei rohrförmige ineinander geschobene konzentrische
Gitter haben sich besonders bewährt.

Durch das Einbringen der zylindrischen Gitter oder Bolzen bestimmter Abmessungen und Größe, die einerseits mit
der unter Spannung stehenden metallischen Befestigung
beispielsweise Buchse und andererseits mit der geerdeten
metallischen Befestigung, die auch eine Buchse sein kann,
verbunden sind, können bestimmte Kapazitäten leicht hergestellt werden.

Die zwei voneinander unabhängigen Metallgitter bzw. ein
Metallgitter und ein Metallbolzen entsprechender Dimensionen erbringen die für den Teilerstützer erforderliche
Kapazität. Ganz wesentlich hierbei ist die Überlappung
der Gitter bzw. die Eintauchtiefe des Bolzens in den
Gitterinnenraum.

Teilerstützer gemäß der Erfindung mit den Einbaumaßen,
Funktionen und Isoliervermögen üblicher Stützisolatoren
sind zusätzlich mit bestimmter Kapazität ausgerüstet und
sind bei Betriebsspannung teilentladungsfrei.

Zur besseren Fixierung und Zentrierung der zylindrischen
Körper, Gitter, Bolzen und dergleichen ist es vielfach
von Vorteil, Kopf- und Fußteile der Isolatoren mit Metallplatten zu versehen, welche die Funktion der Buchsen
übernehmen können. Als besonders geeignet haben sich
Messingplatten erwiesen. Abhängig davon ob der unter
Spannung stehende oder der geerdete Belag (Drahtgitter) außen angeordnet ist, ergibt sich außen am Teilerstützer
eine unterschiedliche Spannungsverteilung, die abhängig
von der Feldgestaltung der vom Teilerstützer getragenen
Anordnung wahlweise zweckmäßig eingesetzt werden kann.
Zum Beispiel kann die Wirkung einer Schraube oder einer
anderen Elektrode, die in der Nähe des Stützerkopfes in
Richtung auf den Stützerfuß übersteht und damit die
Schlagweite verkürzt und die Steckstoßspannung vermindert
durch die feldsteuernde Wirkung des äußeren, unter Spannung stehenden Gitters ganz oder teileweise eliminiert
werden. Diese Feldsteuerung tritt ein bei einer Ausführung nach FIG 1. Bei einer Ausführung nach FIG 2 tritt
die gleiche Wirkung bei einer am Stützerfuß überstehenden
Elektrode ein.

Die Befestigung der Metallgitter bzw. der metallischen
Teile an den Buchsen oder den Metallplatten kann durch
Verlöten, Aufstecken, Anklemmen oder Schrauben erfolgen.

Bei einer bevorzugten Ausführung enthält der Teilerstützer
zwei ineinander geschobene rohrförmige konzentrische
Metallgitter. Weitere bevorzugte Ausgestaltungen der
Erfindung sind in den Unteransprüchen beansprucht.

Geeignete Materialien, insbesondere für die Gitter sind
alle leitenden Materialien, wie z.B. Metalle, Metalllegierungen, metallisierte oder graphitierte Gewebe oder
metallisierte Folien aus Glas, Kunststoff oder Textilien.
Vornehmlich werden Messing und Bronze eingesetzt.

Mit Teilerstützer gemäß der Erfindung ist aufgrund ihrer
festgelegten Kapazität eine Spannungsanzeige wesentlich
einfacher stationär möglich und das Sicherheitsproblem gelöst. Die erfindungsgemäßen Stützer können Bestandteil
jeder beliebigen Schaltanlage werden mit Ausnahme
gasisolierter Schaltanlagen. Sie können in speziellen
Fällen des Anlagenbaues einen normalen Stützisolator
ersetzen.

Die erfindungsgemäße Ausführung eignet sich insbesondere
für Stützisolatoren aus Kunststoff vornehmlich solchen
aus Epoxidharzformstoffen, Polyurethanformstoffen,
Kautschuk, Silikonkautschuk und thermoplastischen
Kautschukarten, die sich aufgrund ihrer Verarbeitungsweise für die Herstellung von teilentladungsfreien Körpern eignen.

Teilerstützer gemäß der Erfindung werden mit besonderem
Vorteil eingesetzt im Lasttrennschalter-, Trennschalter-
und Erdungsschalterbau.

Im folgenden wird die Erfindung anhand der schematischen
Zeichnung näher erläutert.

Gemäß FIG 1 ist in einem Stützisolator 3 aus Gießharz
an der unter Spannung stehenden, als Platte ausgeführten
Buchse 5 ein Messinggitter 4 angeordnet. In dieses Gitter
ragt das an der erdungsseitigen Buchse 2 angebrachte
rohrförmige Messinggitter 1.

FIG 2 zeigt eine Ausführung mit Gitter-Bolzen-Kombination.
Der Metallbolzen 6 ist an der unter Spannung stehenden
Seite eine verlängerte Buchse 8 mit dem halbkugeligen Ende 7. Der Metallbolzen ragt konzentrisch in das
Messinggitter 1 hinein.

FIG 3 zeigt einen Teilerstützer eingeordnet in eine kapazitive Teilerschaltung, zwischen dem unter Spannung stehenden Leiter 12 und Erde 13. Die Kapazität der Teilerstützer 10 ist so gewählt, daß sich mit der außerhalb des Teilerstützers 10 angeordneten Sekundärkapazität 9 ein solches Teilerverhältnis ergibt, daß das zugehörige Anzeigegerät 11 Wechselspannungen bis zu 15% der höchsten Betriebsspannung der Mittelspannungsanlage nicht anzeigt, ab 40 % der Nennspannung der Mittelspannungsanlage aber sicher anzeigt. Gleichspannungen werden nicht angezeigt.

7 Patentansprüche
3 Figuren

Patentansprüche

1. Stützisolator für Hochspannung, insbesondere aus Kunststoff mit eingebauten metallischen Befestigungselementen an der geerdeten und unter Spannung stehenden Seite und einem kapazitiven Spannungsteiler und mit gegebenenfalls angeschlossener elektronischer Schaltung und stationärer Meßeinrichtung zur Feststellung oder Anzeige der Hochspannung oder Freigabe oder Sperrung der Betätigung eines Hochspannungsschalters, g e k e n n - z e i c h n e t  durch eine Teilerkapazität aus einem zylindrischen Metallgitter (1) an einer metallischen Befestigung (2) und einem in das Metallgitter (1) hineinragendes oder es konzentrisch umgebendes metallisches Teil (6, 4) an einer metallischen Befestigung (5, 8).

2. Stützisolator nach Anspruch 1, d a d u r c h  g e - k e n n z e i c h n e t, daß die metallische Befestigung eine als Metallplatte ausgeführte Buchse (5) ist.

3. Stützisolator nach Anspruch 1, d a d u r c h  g e - k e n n z e i c h n e t , daß die metallischen Befestigungen Buchsen (2, 8) sind.

4. Stützisolator nach Anspruch 1, d a d u r c h  g e - k e n n z e i c h n e t , daß das zylindrische Metallgitter (1) an der erdseitigen Metallbuchse (2) und das metallische Teil (4) an der Buchse (5) der unter Spannung stehenden Seite angeordnet ist.

5. Stützisolator nach Anspruch 1, d a d u r c h  g e - k e n n z e i c h n e t , daß das metallische Teil ein zylindrisches Gitter (4) ist.

6. Stützisolator nach Anspruch 5,  g e k e n n -
z e i c h n e t durch zwei ineinandergeschobene
zylindrische konzentrische Gitter (1) und (4).

7. Stützisolator nach Anspruch 1,  d a d u r c h
g ek e n n z e i c h n e t,  daß das metallische Teil
ein Bolzen (6) ist, mit halbkugeligem Ende (7).

0134541
83 P 3264

FIG 1

FIG 2

FIG 3

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| X | EP-A-0 042 788 (AVOCAT)<br>* Seite 1, Zeilen 8-11, 15-20; Seite 2, Zeilen 1-26; Seite 3, Zeilen 3-11; Figur 3 * | 1,3-6 | H 01 B 17/00<br>G 01 R 15/06<br>H 01 B 17/14 |
| Y | | 2,7 | |
| | --- | | |
| Y | DE-A-1 514 703 (SACHSENWERK)<br>* Seite 6, Absatz 2; Seite 7; Figur 3 * | 2,7 | |
| | --- | | |
| A,D | DE-A-3 121 795 (LINDNER)<br>* Seite 7, Absätze 8,9; Seite 8, Absätze 1,3,4; Seite 9, Absatz 1; Figuren 1,3 * | 1-4,7 | |
| | ----- | | |

| RECHERCHIERTE SACHGEBIETE (Int. Cl.4) |
|---|
| H 01 B 17/00<br>H 01 G 4/00<br>G 01 R 15/00<br>H 01 B 17/00 |

Der vorliegende Recherchenbericht wurde für alle Patentansprüche erstellt.

| Recherchenort | Abschlußdatum der Recherche | Prüfer |
|---|---|---|
| DEN HAAG | 05-11-1984 | TIELEMANS H.L.A. |